# EUROPEAN PATENT APPLICATION

(11) **EP 2 413 678 A1**
(43) Date of publication of application: **01.02.2012**
(21) Application number: 11174938.8
(22) Date of filing: 21.07.2011
(51) Int. Cl.: H05K 3/36, H05K 1/14, H05K 3/34

(54) **Printed circuit board unit, method for manufacturing printed circuit board unit, and electronic apparatus**

(30) Priority: 30.07.2010 JP 2010171797
(71) Applicant: FUJITSU LIMITED, Kawasaki-shi, Kanagawa 211-8588 (JP)
(72) Inventor: Watanabe, Manabu, Kawasaki-shi, Kanagawa 211-8588 (JP)
(74) Representative: Holz, Ulrike

(57) **Abstract**

A printed circuit board unit includes a first substrate (24), a second substrate (27), and a spacer (10). The second substrate is coupled to the first substrate via a solder material (26). The second substrate has different coefficient of thermal expansion from the first substrate. The spacer is disposed between the first substrate and the second substrate. The spacer is formed of a thermally-expandable material and a thermosetting material. The thermosetting material has a curing temperature higher than a melting point of the solder material.

## Description

### CROSS-REFERENCE TO RELATED APPLICATION

This application is based upon and claims the benefit of priority of Japanese Patent Application No. 2010-171797, filed on July 30, 2010, the entire contents of which are incorporated herein by reference.

### FIELD

Embodiments discussed herein are related to a printed circuit board unit, a method for manufacturing a printed circuit board unit, and an electronic apparatus.

### BACKGROUND

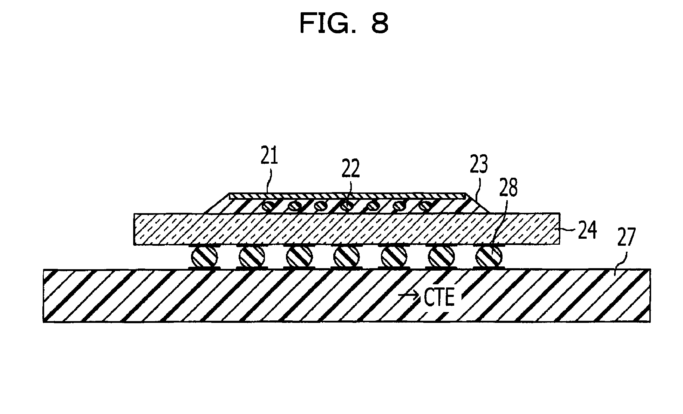

Fig. 8 is a schematic diagram illustrating a printed circuit board 27 (for example, a mother board) on which a semiconductor package, which generally includes a semiconductor chip 21 and a package substrate 24, is mounted. The package substrate 24 and the printed circuit board 27 have a difference in coefficient of thermal expansion. For example, the package substrate 24 is made of a material with a small coefficient of thermal expansion, such as a glass ceramic, and the printed circuit board 27 is made of a material including a resin or the like that has a relatively large coefficient of thermal expansion. Owing to the difference in coefficient of thermal expansion between the package substrate 24 and the printed circuit board 27, the amounts of changes in dimensions of the package substrate 24 and the printed circuit board 27 caused by thermal expansion largely differ from each other. The difference in the amount of change in dimension causes strain, and stress concentration occurs at solder joint 28 between the package substrate 24 and the printed circuit board 27. In particular, the stress tends to concentrate at constricted parts of the solder joint 28, which are barrel shaped, at the side adjacent to the printed circuit board 27. As a result, cracks are generated and the connection reliability between the package substrate 24 and the printed circuit board 27 is reduced.

In this technical field, there has been a demand for increased functionality (larger number of pins). Accordingly, larger package substrates and semiconductor chips have recently been designed. When the size of the package substrate 24 is increased, the difference in the amount of change in dimension between the package substrate 24 and the printed circuit board 27, which difference is caused by thermal expansion owing to the difference in coefficient of thermal expansion, is also increased. As a result, the problem of reduction in connection reliability between the package substrate 24 and the printed circuit board 27 due to the above-described cause has become more serious.

On the other hand, with increasing awareness on environmental protection, restrictions on chemicals used in electronic devices have been enforced. For example, lead-free solders are now used as solders for mounting package substrates. In general, the lead-free solders have higher melting points than that of lead solder, and do not easily creep. Therefore, when the strain in the joint between the package substrate 24 and the printed circuit board 27 is increased as described above, the lead-free solders do not creep to follow the strain as smoothly as the lead solder. As a result, when a lead-free solder is used, there is a risk that the connection reliability between the package substrate 24 and the printed circuit board 27 will be further reduced compared to the case in which the lead solder is used.

Accordingly, Japanese Unexamined Patent Application Publications Nos. 2001-094002 and 2006-339491 disclose structures in which spacer members are provided between the semiconductor package and the printed circuit board.

However, when thermally-expandable spacer members are simply arranged between the package substrate and the printed circuit board, the following problem occurs. That is, when the temperature returns to an room temperature after a reflow process and the solder joint is solidified by being cooled, the spacer members contract again. Therefore, it is difficult to accurately control the mounting height of the package substrate.

### SUMMARY

According to an embodiment of the invention, a printed circuit board unit is provided with a first substrate, a second substrate, and a spacer. The second substrate is coupled to the first substrate via a solder material. The second substrate has different coefficient of thermal expansion from the first substrate. The spacer is disposed between the first substrate and the second substrate. The spacer is formed of a thermally-expandable material and a thermosetting material. The thermosetting material has a curing temperature higher than a melting point of the solder material.

The object and advantages of the invention will be realized and attained at least by the elements, features, and combinations particularly pointed out in the claims. It is to be understood that both the foregoing general description and the following detailed description are exemplary and explanatory, and are not restrictive of the invention.

### BRIEF DESCRIPTION OF DRAWINGS

Fig. 1 is a schematic diagram illustrating a spacer according to a first embodiment of the present invention;

Fig. 2 is a schematic diagram illustrating a method for manufacturing a printed circuit board unit according to a second embodiment of the present invention;

Fig. 3 is a schematic diagram illustrating a method for manufacturing the printed circuit board unit in reflow process according to the first embodiment of the present invention;

Fig. 4 is a schematic diagram illustrating a method for manufacturing the printed circuit board unit in reflow process according to the first embodiment of the present invention;

Fig. 5 is a schematic diagram illustrating a method for manufacturing the printed circuit board unit in reflow process according to the first embodiment of the present invention;

Fig. 6 is a graph of the relationship between the temperature difference (ΔT) and the amount of change in dimension of four types of spacers according to an embodiment of the present invention;

Fig. 7 is a graph of the relationship between the mounting height and the temperature cycle life of a printed circuit board unit according to an embodiment of the present invention and a printed circuit board unit of a comparative example;

Fig. 8 is a schematic diagram illustrating the printed circuit board unit according to the related art; and

Fig. 9 is a schematic diagram illustrating an electronic apparatus according to an embodiment of the present invention.

### DESCRIPTION OF EMBODIMENTS

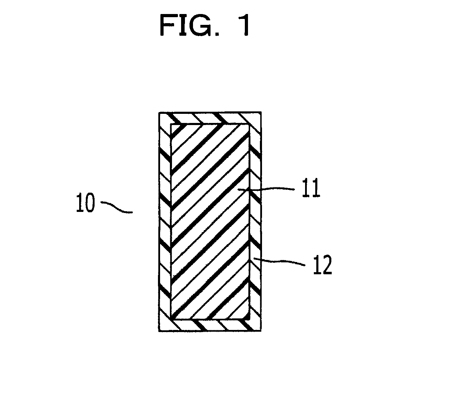

Embodiments of the present invention will now be described with reference to the drawings. Fig. 1 is a schematic diagram illustrating the structure of a spacer 10 according to a first embodiment of the present invention. In one embodiment, the spacer 10 is placed between a package substrate 24 and a printed circuit board 27 to accurately control a mounting height of the package substrate 24 with respect to the printed circuit board 27 in a reflow process.

The spacer 10 may include a body portion 11 and a coating portion 12 surrounding the body portion 11. The body portion can contain a thermally-expandable material. The coating portion 12 can contain a thermosetting material. The thermosetting material forming the coating portion 12 has a curing temperature (Th) higher than a melting point (Tm) of the solder bumps which are provided on the package substrate 24. According to an embodiment, the body portion 11 contains the thermally-expandable material, and linearly expands as the temperature increases. The coefficient of linear expansion of the spacer 10 (the thermally-expandable material) is larger than that of the solder material.

Therefore, when the package substrate 24 is soldered to the printed circuit board 27 through a reflow process, the body portion 11 of the spacer 10 linearly expands in a vertical direction until the temperature reaches the curing temperature (Th) of the coating portion 12. When the reflow temperature reaches the curing temperature (Th) of the coating portion 12, the thermosetting material contained in the coating portion 12 is cured. On the other hand, the body portion 11 linearly expands during reflow by an amount corresponding to the temperature difference between the curing temperature (Th) and room temperature. The temperature difference, the coefficient of thermal expansion of the body portion 11, and the dimension of the body portion 11 affect the expansion amount of the body portion during reflow. Once the reflow is completed, the printed circuit board unit can be conveyed outside the reflow chamber, and thus the ambient temperature is reduced to room temperature. Nevertheless, thermal contraction of the body portion 11 is suppressed because the coating portion 12 is already cured during the reflow process. Thus, the mounting height of the semiconductor package may be accurately set by employing the above-mentioned spacer 10.

In one embodiment, the curing temperature (Th) of the coating portion 12 is set to be higher than a melting point (Tm) of a solder joint material used to connect the package substrate 24 to the printed circuit board 27. The solder joint material may include solder bumps provided on the bottom surface of the package substrate 24 and solder pastes provided on the top surface of the printed circuit board 27. If the curing temperature of the coating portion 12 is lower than the melting point of the solder joint (Th < Tm), the coating portion 12 of the spacer 10 is cured, and, thus, the thermal expansion of the body portion 11 is stopped even before the solder joint material becomes melted. As a result, the desired mounting height cannot be obtained.

Various materials known as thermosetting adhesives may be used for the coating portion 12. For example, phenol resin (PF), epoxy resin (EP), melamine resin (MF), urea resin (UF), unsaturated polyester resin (UP), alkyd resin, polyurethane (PUR), and thermosetting polyimide (PI) may be used. The curing temperatures of phenol resin (PF), epoxy resin (EP), melamine resin (MF), urea resin (UF), unsaturated polyester resin (UP), and alkyd resin are about 120°C to 200°C. The curing temperature of polyurethane (PUR) is about 60°C to 100°C, and that of thermosetting polyimide (PI) is about 200°C to 400°C.

The body portion 11 includes a material having a certain coefficient of thermal expansion. The thermally-expandable material of the body portion 11 may be selected from a material having a certain coefficient of thermal expansion such that the body portion 11 accomplishes linear expansion greater than the solder joint by a desired amount in the height direction when the reflow temperature reaches the curing temperature (Th) of the coating portion 12. The thermally-expandable material may be preferably selected from high-heat-resistance plastics, and more preferably, from plastic materials categorized as "super engineering plastics" in accordance with the desired coefficient of thermal expansion. For example, polyphenylene sulfide (PPS), polyarylate (PAR), polyetherimide (PEI), polysulfone (PSF), polyethersulfone (PES), polyether ketone (PEK), polyether ether ketone (PEEK), polyimide (PI), polyamidoimide (PAI), and polytetrafluoroethylene (PTFE) may be used.

The shape of the body portion 11 is not particularly limited. For example, the shape of the body portion 11 may be selected as appropriate from various shapes such as a pillar shape (a circular columnar shape, a rectangular parallelepiped shape, a cubic shape, a polygonal columnar shape, etc.), a plate shape, and a spherical shape in accordance with the structures of the package substrate 24 and the printed circuit board 27 to be connected, and limitations regarding processing thereof, etc. In the present embodiment, the surface of the body portion 11 may be covered (surrounded) by the coating portion 12 having a thermosetting property. Alternatively, the spacer may be formed by dispersing thermosetting resin powders into a matrix of thermally-expandable material. Also, the spacer 10 may be formed of a material having both thermal-expansion and thermosetting property.

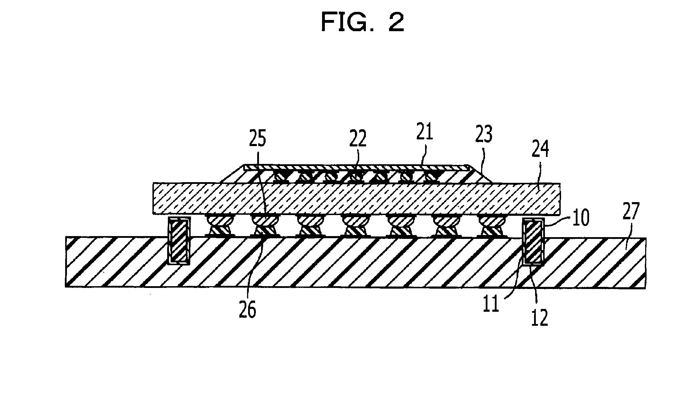

The vertical length (height) of the body portion 11 can be determined based on the amount of thermal expansion to be accomplished and the coefficient of thermal expansion of the material of the body portion 11. For example, in the case of a body portion 11 whose initial height at room temperature is greater than the distance (stand-off height) between the package substrate 24 and the printed circuit board 27, the spacer 10 may be partially affixed within a recess provided on the printed circuit board 27 as illustrated in the example of Fig. 2. Alternatively, the spacer 10 can be partially affixed within a through hole provided in the printed circuit board 27, and the bottom end of the spacer 10 may be secured at an appropriate location in the through hole. Also, the through hole may be formed in the package substrate 24 to secure the top end of the spacer 10 therein.

On the other hand, in the case of a body portion 11 whose initial height at room temperature is smaller than the distance (stand-off height) between the package substrate 24 and the printed circuit board 27, an auxiliary member may be placed between the spacer 10 and the printed circuit board 27 and/or the package substrate 24 so as to absorb the distance gap.

Hereinafter, a method for manufacturing a printed circuit board unit according to a second embodiment of the present invention will be described with reference to Figs. 2 to 5.

Fig. 2 illustrates a method for manufacturing a printed circuit board unit provided with the spacer 10, the package substrate 24, and the printed circuit board (e.g., a mother board) 27, according to one embodiment. A semiconductor chip 21 is electrically flip-chip mounted on the top surface of the package substrate 24 with conductive bumps 22 provided therebetween. Ball grid array (BGA) solder bumps 25 may be placed on electrodes provided on the bottom surface of the package substrate 24. Solder pastes 26 can be placed on electrodes provided on the top surface of the printed circuit board 27. In addition, the spacers 10 according to the first embodiment of the present invention are arranged on the top surface of the printed circuit board 27. The package substrate 24 and the printed circuit board 27 may be arranged such that the solder bumps 25 are opposed to the corresponding solder pastes 26. Here, the printed circuit board 27 may be regarded as a first substrate according to the present invention, and the package substrate 24 may be regarded as a second substrate according to the present invention.

In the second embodiment, when the package substrate 24 has a rectangular parallelepiped shape, the spacers 10 may be disposed on the printed circuit board 27 at positions corresponding to the four corners of the package substrate 24. However, the positions at which the spacers 10 are arranged may be set as appropriate in accordance with a shape of a package substrate, arrangements of electronic components, and circuit patterns, etc., taking into consideration processing. In the second embodiment, the spacers 10 are placed on the top surface of the printed circuit board 27. Alternatively, the spacers 10 may be provided on the bottom surface of the package substrate 24.

In the second embodiment, the semiconductor chip 21 may be electrically flip-chip mounted on the package substrate 24 with the conductive bumps 22 provided therebetween, and an underfill layer 23 can be provided so as to fill the gap between the package substrate 24 and the semiconductor chip 21. However, this structure is merely an example, and the present embodiment is not limited in any way to this example.

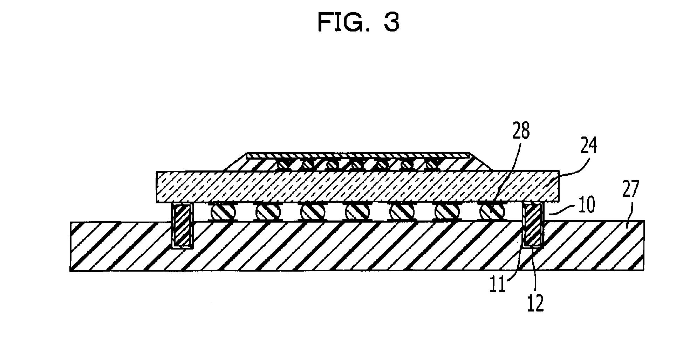

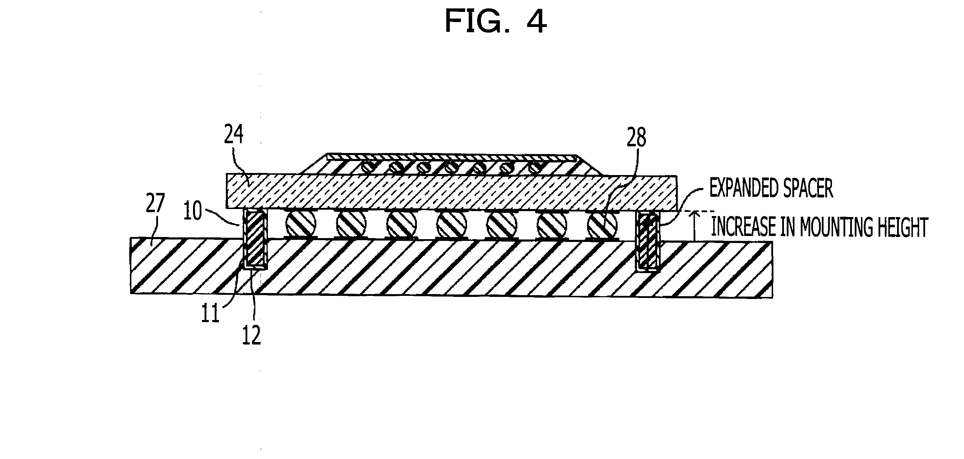

In the state in which the package substrate 24 and the printed circuit board 27 are positioned as described above, the package substrate 24 and the printed circuit board 27 are heated to reflow the solder bumps 25 and the solder pastes 26. When the temperature of the solder bumps 25 and the solder pastes 26 reaches the melting point thereof, the solder bumps 25 and the solder pastes 26 melt and are combined with each other due to surface tension, as illustrated in the example of Fig. 3. Thus, the package substrate 24 and the printed circuit board 27 are electrically connected to each other. Then, as illustrated in Fig. 4, the body portions 11 having a certain coefficient of thermal expansion, thermally expand in the height (longitudinal) direction and push up (uplift) the package substrate 24 as the temperature increases. As a result, the distance (stand-off height) between the package substrate 24 and the printed circuit board 27 is increased by the spacers 10 while solder joint 28 are in a molten state. Until the temperature reaches the curing temperature of the coating portions 12 of the spacers 10, the body portions 11 continue to thermally expand in the height direction.

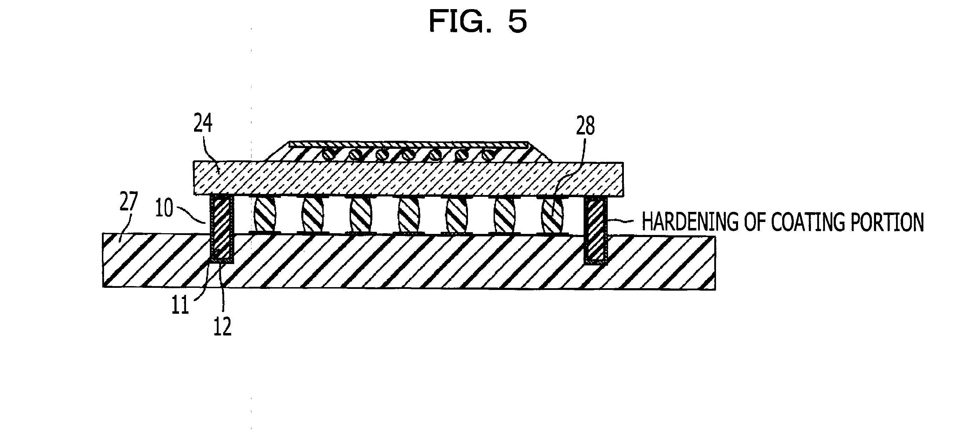

When the temperature is further increased and reaches the curing temperature (Th) of the thermosetting material contained in the coating portions 12, the coating portions 12 are cured with the thermal expansion amount of the body portions 11 corresponding to the curing temperature (Th), as illustrated in Fig. 5. Once the coating portions 12 are cured, further thermal-expansion of the body portions 11, which are surrounded by the cured coating portions 12, is restrained. This allows the printed circuit board unit to maintain the uplifted stand-off height. After the reflow process, the temperature returns to the room temperature. However, since the coating portions 12 have been already cured, the spacers 10 do not thermally contract and the uplifted stand-off height is still maintained. As a result, the desired mounting height is reliably obtained. Accordingly, in one example, a shape of the solder joint 28 is formed similar to a pillar in accordance with the increase in the stand-off height. Thus, even when thermal strain is propagated to the solder joint 28 due to difference in the coefficient of thermal expansion between the package substrate 24 and the printed circuit board 27, the thermal stress may be dispersed over the entire bodies of the pillar-shaped solder joint 28 as compared to the barrel-shaped solder joint in the related art. As a result, defects such as cracks in a solder joint may be effectively reduced.

With the spacer according to the first embodiment of the present invention, the amount of thermal expansion of the body portion in the vertical (longitudinal) direction may be accurately controlled by selecting a thermosetting material having a certain curing temperature (Th) as the coating portion, or by selecting a thermally-expandable material having a certain coefficient of thermal expansion as the body portion. By employing the spacer according to the first embodiment of the present invention, thermally-expanded spacer may be cured in the reflow process while the package substrate 24 is uplifted with the molten solder joint. Even when the temperature is reduced to the room temperature after the reflow process, the uplifted height of the spacer may be maintained. As a result, the mounting height of the package substrate with respect to the printed circuit board may be accurately controlled to a desired height.

According to embodiments of the present invention, despite a difference of coefficient of thermal expansion between the package substrate and the printed circuit board in the soldering process, thermal stresses may be suppressed from concentrating on the constricted parts of the solder joint, and be dispersed over the entire bodies of the pillar-shaped solder joint 28. This allows for an improvement in the connection reliability of the solder joint in the printed circuit board unit.

As an acceleration test for evaluating the connection reliability of an electronic component, a heat cycle test under the conditions described below may be performed. Specifically, each solder joint to be tested is electrically connected in series with a daisy chain configuration to form a circuitry. A given direct current (DC) is applied to the circuitry. In this state, the temperature is set to -65°C for 15 minutes, to the room temperature for 2 minutes, and to 125°C for 15 minutes. The heat cycle is repeated. Since each solder joint is electrically connected with the daisy chain configuration, the direct current stops flowing when the electrical connection is terminated at any of the solder joint. The number of the heat cycles which have been repeated until the direct current is interrupted, is recorded. This may be used as an index of the connection reliability. The larger the recorded heat cycles, the higher the connection reliability in solder joints.

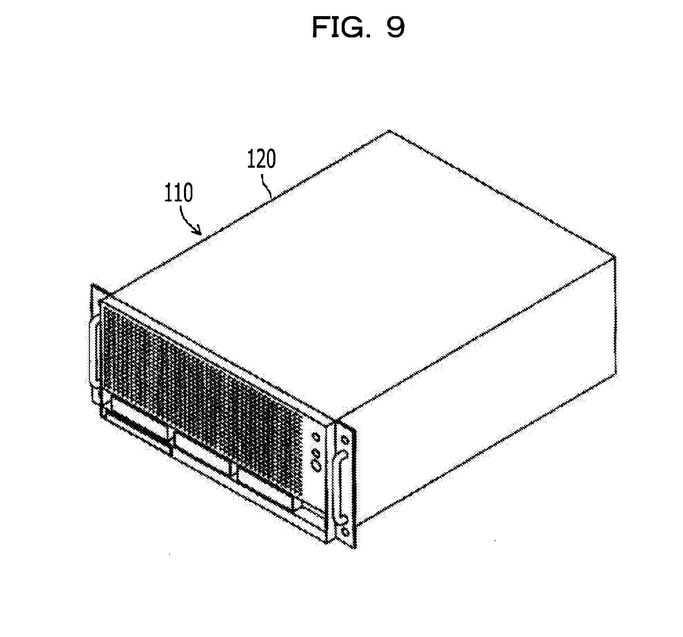

Fig. 9 is a schematic diagram illustrating a server computer 110 as an example of an electronic apparatus according to the present invention. The server computer 110 includes an enclosure 120. A housing space is provided in the enclosure 120. A board unit including a mother board, which is an example of a printed circuit board 27, and a semiconductor package mounted on the mother board is placed in the housing space. Another example of the electronic apparatus according to the present invention is a supercomputer.

In the above description, the solder joint between the semiconductor package and the printed circuit board, such as a mother board, is explained. However, the above-described embodiments may also be applied to a solder joint between other types of substrates, such as a semiconductor chip and a package substrate. Also in this case, the connection reliability may be enhanced.

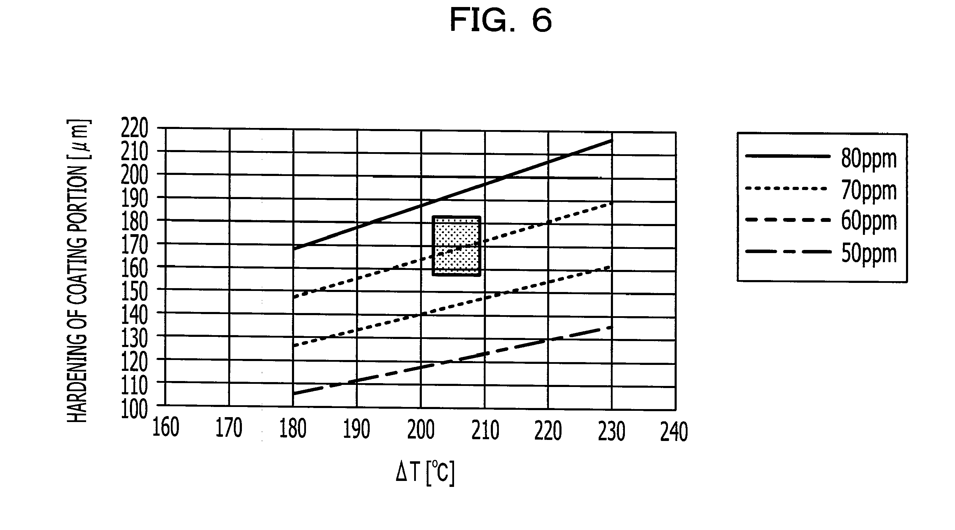

Hereinafter, experimental examples according to embodiments of the invention are explained. As a body portion of a spacer, four types of high-heat-resistance plastics each of which has different coefficients of thermal expansion (50 ppm/°C, 60 ppm/°C, 70 ppm/°C, and 80 ppm/°C) were prepared as seen in the example of Fig. 6. The height of these components was set to 3.43 mm. The above components were coated with thermosetting epoxy resin having a curing temperature of about 230°C by dip coating. The coating portion was formed, and the spacer was completed. Assuming that the room temperature is 25°C, the temperature difference (ΔT) between the room temperature and the curing temperature of the spacer is 230°C - 25°C = 205°C.

In the experiments, it was aimed that 430 µm of the initial stand-off height of the package substrate is to be uplifted to 600 µm by using the above-mentioned spacer. Therefore, 170 µm of the stand-off height is to be increased by thermal expansion of the spacer in the height (vertical) direction. Fig. 6 illustrates a graph of the relationship between the temperature difference (ΔT) and the amount of thermal expansion according to the four types of spacers. Referring to the example of Fig. 6, it may be concluded that the spacer having a coefficient of thermal expansion of 70 ppm/°C is to be used for achieving the aimed stand-off height of 170 µm at the above-mentioned temperature difference (ΔT = 205°C) (see the box-shaped area in Fig. 6). Thus, the structure of spacers (combination of materials of the body portion and the coating portion) may be determined by the above-described procedure in accordance with the desired mounting height of the package substrate.

With the spacer having the coefficient of thermal expansion of 70 ppm/°C and the curing temperature of 230°C, a mounting experiment of a BGA semiconductor package was performed on a printed circuit board in accordance with embodiments of the invention with reference to Figs. 2 to 5.

As described above, in this example, the mounting height of the semiconductor package that is 430 µm without spacers is to be increased to 600 µm by using the spacers having a curing temperature of 230°C and a coefficient of thermal expansion of 70 ppm/°C. Therefore, it is desirable that the amount of projection of the spacers from the printed circuit board is 430 µm at the room temperature (25°C) before the reflow heating process, and is 600 µm at the curing temperature (Th = 230°C) of the coating portions of the spacers. Accordingly, the spacers of this example, which have a height of 3.43 mm, were placed between the printed circuit board and the package substrate such that the spacers were embedded by 3 mm in recesses formed in the printed circuit board. In this example, the reflow temperature was about 250°C.

A temperature acceleration test was performed under the above-described conditions by using a semiconductor package according an embodiment of the present invention that was mounted as described above and a semiconductor package according to a comparative example without using spacers. Thus, the connection reliability of the solder joint was evaluated for each semiconductor package.

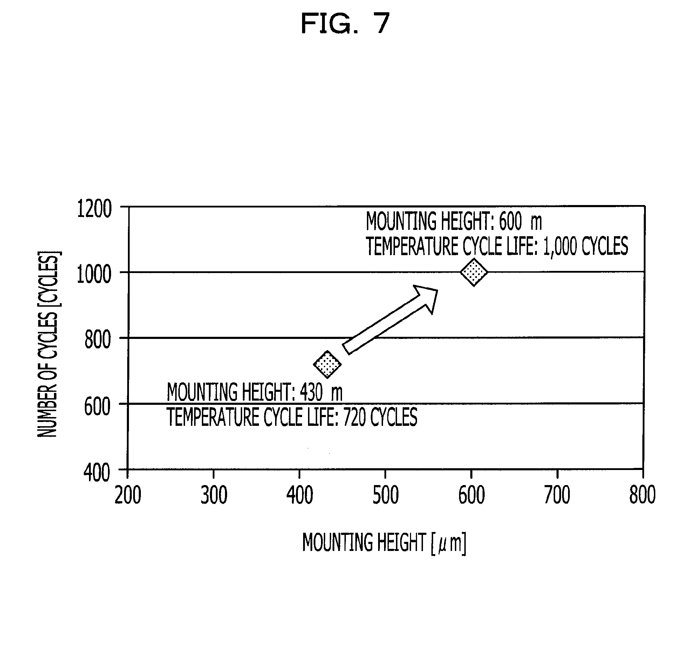

Fig. 7 illustrates a graph of the relationship between the mounting height and the number of times the heat cycle was repeated in the temperature accelerated test for the semiconductor package of the example and the semiconductor package of the comparative example. As is clear from Fig. 7, in the semiconductor package manufactured by using the spacers according to the present example, the mounting height was increased from 430 µm to 600 µm, compared the semiconductor package of the comparative example. According to the increase in the mounting height, the number of times the temperature cycle was repeated in the temperature accelerated test was largely increased from 720 to 1,000.

As is clear from this result, the mounting height of the semiconductor package with respect to the printed circuit board may be accurately controlled by using the spacers according to embodiments of the present invention which are coated with a coating material having a curing temperature higher than or equal to a melting point of the solder. As a result, the connection reliability of the solder joint may be largely increased.

All examples and conditional language recited herein are intended for pedagogical objects to aid the reader in understanding the invention and the concepts contributed by the inventors to further the art, and are to be construed as being without limitation to such specifically recited examples and conditions, nor does the organization of such examples in the specification rotate to a showing of the superiority or inferiority of embodiments of the invention. Although the embodiments of the invention have been described in detail, it will be understood by those of ordinary skill in the relevant art that various changes, substitutions, and alterations could be made hereto without departing from the spirit and scope of the invention as set forth in the claims.

In any of the above aspects, the various features may be implemented in hardware, or as software modules running one or more processors. Features of one aspect may be applied to any of the other aspects.

The invention also provides a computer program or a computer program product for carrying out any of the methods described herein, and a computer readable medium having stored thereon a program for carrying out any of the methods described herein. A computer program embodying the invention may be stored on a computer-readable medium, or it could, for example, be in the form of a signal such as a downloadable data signal provided from an Internet website, or it could be in any other form.

## Claims

1. A printed circuit board unit comprising:
a first substrate;
a second substrate coupled to the first substrate via a solder material, the second substrate having different coefficients of thermal expansion; and
a spacer disposed between the first substrate and the second substrate, the spacer formed of a thermally-expandable material and a thermosetting material,
wherein the thermosetting material has a curing temperature higher than a melting point of the solder material.

2. The printed circuit board unit according to claim 1, wherein a distance between the first substrate and the second substrate is determined by a height of the spacer in a cured state.

3. The printed circuit board unit according to claim 1 or 2, wherein the second substrate is soldered onto the first substrate, and
the spacer is arranged on the first substrate at a position corresponding to a corner portion of the second substrate.

4. The printed circuit board unit according to any of claims 1 to 3, wherein the spacer comprises a body portion containing the thermally-expandable material, and a coating portion containing the thermosetting material to surround the body portion.

5. The printed circuit board unit according to any of claims 1 to 4, wherein the thermally-expandable material and the thermosetting material are configured to be integrated in the spacer.

6. The printed circuit board unit according to claim 5, wherein the thermosetting material in a powdered state is dispersed in a matrix of the thermally-expandable material.

7. The printed circuit board unit according to any of claims 1 to 6, wherein the thermally-expandable material has a coefficient of linear expansion greater than the solder material.

8. A method for manufacturing a printed circuit board unit, the method comprising:
disposing a spacer formed of a thermally-expandable material and a thermosetting material between a first substrate and a second substrate, the second substrate having different coefficients of thermal expansion from the first substrate;
providing a solder material on at least one of the first substrate and the second substrate; and
reflowing the first substrate and the second substrate equal or above a curing temperature of the thermosetting material in the spacer, the thermosetting material having a curing temperature higher than a melting point of the solder material.

9. An electronic apparatus comprising:
an enclosure; and
a printed circuit board unit incorporated in the enclosure, the printed circuit board unit comprising
a first substrate;
a second substrate coupled to the first substrate via a solder material, the second substrate having different coefficients of thermal expansion; and
a spacer disposed between the first substrate and the second substrate, the spacer formed of a thermally-expandable material and a thermosetting material,
wherein the thermosetting material has a curing temperature higher than a melting point of the solder material.
